# EUROPEAN PATENT SPECIFICATION

(11) **EP 2 561 552 B1**
(45) Date of publication and mention of the grant of the patent: **24.01.2018**
(21) Application number: 11772264.5
(22) Date of filing: 22.04.2011
(51) Int. Cl.: H01L 31/042, H01L 31/18

(54) **BACK SHEET FOR SOLAR CELL MODULE AND MANUFACTURING METHOD THEREOF**
RÜCKSEITENFOLIE FÜR EIN SOLARZELLENMODUL UND HERSTELLUNGSVERFAHREN DAFÜR
FEUILLE D'ENVERS POUR MODULE DE CELLULE SOLAIRE, ET SON PROCÉDÉ DE FABRICATION

(30) Priority: 23.04.2010 KR 20100037769
(43) Date of publication of application: 27.02.2013
(73) Proprietor: Kolon Industries, Inc., Gwacheon-si, Gyeonggi-do 13837 (KR)
(72) Inventor: CHOI, Suk Won, Busan 611-770 (KR); BAEK, Sang-Hyun, Gumi-si, Gyeongsangbuk-do 730-040 (KR)
(74) Representative: Ter Meer Steinmeister & Partner
(86) International application number: PCT/KR2011/002909
(87) International publication number: WO 2011/132976

(56) References cited:
- JP-A- 2006 270 025
- JP-A- 2009 071 236
- JP-A- 2009 290 201
- US-A1- 2009 275 251

## Description

### Technical Field

The present invention relates to a back sheet for a solar cell module, and more particularly, to a back sheet having improved adhesiveness to a fluorine coating layer and reduced production costs, which is fabricated by applying a fluorine coating layer to a polyester film through coating, compared to conventional methods such that a back sheet is formed of a laminate including PVF (Tedlar) film/PET film/PVF (Tedlar) film ('TPT type') by using an adhesive to adhere and laminate these films to each another.

### Background Art

A solar battery for solar power generation is configured of silicon or other various compounds and becomes a solar cell form to generate electrical energy. However, since one solar cell cannot provide sufficient energy, a plurality of cells should be arranged in series or parallel and such arrangement is generally called a solar cell module.

The solar cell module is fabricated by laminating a back sheet, an EVA, a solar cell, an EVA and a glass layer, in sequential order. The back sheet is a material to form the bottom of the module and often made of a TPT type material, and a ribbon used as a current path is made of a copper material coated with silver or tin-lead.

The back sheet for a solar cell module is an important material (as an outermost layer) that is located on the back side of the solar cell module because it protects the cell. Since various characteristics such as durability, weatherproof property, insulation, waterproof property, or the like are required, the back sheet is usually fabricated by laminating a fluorine film and a PET film.

In this regard, the fluorine film may have favorable weatherproof property and durability. At present, a Tedlar film made of a PVF resin, which was developed by DuPont in 1961, has been generally used. However, due to lack of provision of Tedlar films, some manufacturers use other films such as PET in place of the Tedlar film.

Another material for a solar cell used in a satellite, EVA, was created by joint development of NASA and DuPont in 1970. EVA has been currently used as a standard sealing material for a solar cell. In this field, a Japanese company, Mitsui Chemical (Bridgestone), dominates 70% or more of the global market. The sealing material functions to seal individual cells and charge the same inside the solar cell, and has excellent strength, transparency and insulating property.

A polyethylene terephthalate (PET) film is made of a planar plastic film having a predetermined thickness and physical properties, and shows high strength sufficient to form a fundamental framework of the back sheet. This material has excellent physical, chemical, mechanical and/or optical properties, to thereby be used in a wide range of applications including, for example, a food package, office products, advanced electrical and electronic products such as a semiconductor or a display, or the like. Because of high durability and weatherproof property, use of the PET film as a back sheet for a solar cell has recently increased.

In addition, a glass having reduced content of iron may be utilized to prevent light reflection.

According to conventional methods, a TPT type back sheet needs to be laminated by a Tedlar film and a PET film, which are adhered thereon by using an adhesive and, in order to adhere an EVA film as a sealing material to the back sheet, a process of adhering the EVA film to the back sheet by using a polyurethane adhesive or the like is additionally required. However, the Tedlar film is expensive and even accounts for 80% or more of the total production cost of the back sheet, thus causing an increase in price of the back sheet. US 2009/275251A1 discloses a backsheet for solar cell module with the following build-up: composition A/composition B/PET. Composition A comprises 50 to 70 parts of PVDF and 10 to 25 parts of a mineral filler (preferably titanium dioxide). Adhesive composition B comprises 5 to 40 parts of PVDF and 60 to 95 parts of PMMA. The PVDF- based film is preferably manufactured by extrusion but it is also possible to use a coating technique.

### Disclosure of Invention

### Technical Problem

As a result of extensive studies to solve the conventional problems in the above processes due to multi-staged application of an adhesive and to overcome a price increase caused by the use of a Tedlar film, the inventors found that, if a fluorine coating composition is applied to a polyester film via off-line coating to form a fluorine coating layer as a replacement of the existing Tedlar film layers, processes and cost may be advantageously reduced, thus completing the present invention.

Also, it was found that adhesiveness between a fluorine coating layer and a polyester film may be improved when a easy-adhesive acryl coating layer is formed on either or both sides of the polyester film in order to improve adhesiveness between the fluorine coating layer and the polyester film and the present invention was completed on the basis of the foregoing finding. Specifically, it was found that, if the easy-adhesive acryl coating layer is formed by in-line coating during production of a polyester film, adhesiveness between the acryl coating layer and the polyester film may be improved, thus completing the present invention.

That is, an object of the present invention is to develop a fluorine coating composition replaceable for a Tedlar film layer in a laminate structure consisting of Tedlar film/PET film/Tedlar film, which has been used in the existing back sheet for a solar cell module, thus decreasing the price of a product.

Another object of the present invention is to provide a back sheet film having excellent adhesiveness by forming a easy-adhesive acryl coating layer, in order to improve adhesiveness between the fluorine coating composition and a polyester film.

### Solution to Problem

In order to solve the foregoing problems, in one general aspect, the present invention is characterized by forming a fluorine coating layer through off-line coating by using a fluorine coating composition with excellent physical properties, thus replacing a Tedlar film in a conventional laminate structure that includes Tedlar film/PET film/Tedlar film, with a fluorine coating layer.

However, in case where the fluorine coating composition is applied to a PET film through off-line coating, adhesiveness may be reduced, thus causing delamination. Therefore, the inventors have found that adhesiveness of a fluorine coating layer may be improved by applying a water-dispersible composition (emulsion) through in-line coating during stretching in a process of manufacturing the PET film, in order to form a easy-adhesive acryl coating layer on a PET film, while reducing a coating thickness. As a result, the present invention was completed.

More particularly, the present invention provides a back sheet for a solar cell module, including: a polyester film layer having a easy-adhesive acryl coating layer formed on either or both sides thereof; and a fluorine coating layer prepared by applying a fluorine coating composition containing titanium dioxide as well as a fluoride resin selected from polyvinylidene fluoride or tetrafluoroethylene-hexafluoropropylene-vinylidene fluoride, to a top side of the acryl coating layer, wherein the adhesive acryl coating layer is formed by applying an acrylic emulsion containing 2 to 10wt.% of an acryl binder resin, 0.2 to 4wt.% of a melamine based cross-linking agent, 0.02 to 0.5wt.% of a curing catalyst and water as the remaining amount to equal 100.wt%.

The present invention also provides a method of fabricating a back sheet for a solar cell module, the method including: a) preparing a polyester sheet by melt-extruding a polyester resin; b) stretching the polyester sheet in a machine direction; c) applying an acryl emulsion that contains 2 to 10wt.% of an acryl binder resin, 0.2 to 4wt.% of a melamine based cross-linking agent, 0.02 to 0.5wt.% of a curing catalyst and water as the remaining amount to equal 100wt.% to either or both sides of the polyester film stretched in the machine direction, to form a easy-adhesive acryl coating layer, and then, stretching the coated polyester film in a transverse direction; d) heat-setting the biaxial oriented polyester film; and e) applying a fluorine coating composition that contains titanium dioxide as well as a fluorine resin selected from polyvinylidene fluoride or tetrafluoroethylene-hexafluoropropylene-vinylidene fluoride, to a top side of the easy-adhesive acryl coating layer, through off-line coating, in order to form a fluorine coating layer.

Hereinafter, the present invention will be described in detail.

The polyester film of the present invention may be formed by using polyethylene terephthalate, polyethylene naphthalate, or the like.

The present invention forms a easy-adhesive acryl coating layer on either or both sides of the polyester film through in-line coating during production thereof. The present invention may use the easy-adhesive acryl coating layer to form a fluorine coating layer on the polyester film.

The easy-adhesive acryl coating layer may have a dry coating thickness of 50 to 300nm to provide excellent adhesiveness.

The easy-adhesive acryl coating layer is prepared of an acryl based emulsion containing 2 to 10wt.% of an acryl binder resin, 0.2 to 4wt.% of a melamine based cross-linking agent, 0.02 to 0.5wt.% of a curing catalyst, and water as the remaining amount to equal 100wt.%.

The acryl binder resin may include an acryl resin such as methylmethacrylate, ethyl-methacrylate, isobutylmethacrylate, normal butylmethylmethacrylate, a copolymer or terpolymer of acrylic acid and methacrylic acid, or the like. The acryl binder resin may be an acryl binder commercially available in the market, for example, Primal 1018 as a two-liquid type binder or Primal-3208 as a one-liquid type binder (Dow Co.), or the like. The content range described above means content in a solid state, that is, a solid content.

The melamine based cross-linking agent may increase a cross-linkage density of the acryl binder, improve close adhesion of the same to a polyester film, adhesiveness of the same to a fluorine coating layer during post processing. More particularly, methoxymethyl methylol melamine is preferably used and the content thereof may range from 0.2 to 4wt.%. More preferably, the content ranges from 0.5 to 3wt.%.

Moreover, the curing catalyst may include ammonium thiocyanate. A content of the curing catalyst may range from 0.02 to 0.5wt.% in order to increase a curing degree of the acryl binder.

According to the present invention, the fluorine coating layer is used for replacing a fluorine film consisting of polyvinyl fluoride (PVF) and is formed by applying a fluorine coating composition to a top side of the easy-adhesive acryl coating layer through off-line coating, and then, drying the same.

The fluorine coating composition of the present invention may include a fluorine resin selected from polyvinylidene fluoride or tetrafluoroethylene-hexafluoropropylene-vinylidene fluoride, as well as titanium dioxide.

The fluorine resin may be polyvinylidene fluoride, tetrafluoroethylene-hexafluoropropylene-vinylidene fluoride, or the like, however, is not particularly limited thereto, so far as the fluorine resin is soluble in a solvent and useable for off-line coating. The fluorine resin may be contained in an amount of 10 to 30wt.% relative to a total weight of the fluorine coating composition, in order to provide a suitable dry coating thickness.

Titanium dioxide may be a rutile type having a particle diameter of 150 to 300nm to implement excellent UV shielding property. A content of the rutile type titanium dioxide may range from 30 to 40wt.% in respects to the amount of the fluorine resin. That is, in relation to a total weight of the fluorine coating composition, 3 to 12wt.% of the rutile type titanium dioxide is preferably used.

In order to apply the fluorine coating composition through off-line coating, a resin may be used after dissolving the same in a solvent or the like. The useable solvent may include a hydrocarbon based solvent, a ketone based solvent, or the like. Dimethyl acetamide, dimethyl formamide, N-methyl-2-pyrrolidone, or the like, is preferably used.

Such an off-line coating method may include roll coating, die coating, comma coating, or the like. Preferably, coating may be executed to provide a dry coating thickness of 10 to 30*µ*m, to thereby exhibit excellent UV shielding property.

Continuously, a method of fabricating a back sheet according to the present invention will be described in detail.

According to the present invention, the fabricating method may include: melt-extruding a polyester resin to prepare a sheet, mono-axially stretching the sheet, applying an acryl emulsion and bi-axially stretching the coated sheet in a transverse direction to form a polyester film; and applying a fluorine coating composition to the formed polyester film.

More particularly, the method of fabricating a back sheet may include: a) preparing a polyester sheet by melt-extruding a polyester resin; b) stretching the polyester sheet in a machine direction; c) applying an acryl emulsion that contains 2 to 10wt.% of an acryl binder resin, 0.2 to 4wt.% of a melamine based cross-linking agent, 0.02 to 0.5wt.% of a curing catalyst and water as the remaining amount to equal 100wt.% to either or both sides of the polyester film stretched in the machine direction to form a easy-adhesive acryl coating layer, and then, stretching the coated polyester film in a transverse direction; d) heat-setting the biaxially stretched polyester film; and e) applying a fluorine coating composition that contains titanium dioxide as well as a fluorine resin selected from polyvinylidene fluoride or tetrafluoroethylene-hexafluoropropylene-vinylidene fluoride, to a top side of the easy-adhesive acryl coating layer, through off-line coating, in order to form a fluorine coating layer.

If it is necessary, corona treatment may be executed before applying the acryl emulsion or before applying the fluorine coating composition.

Step (a) is a process of preparing a polyester film by melt-extruding a resin through a cylinder and passing the same through a T-die to form a sheet.

Step (b) is a process of preparing a polyester film by biaxially stretching the polyester sheet and the stretching in a machine direction is preferably conducted by using at least one roller.

Step (c) is a process of forming a easy-adhesive acryl coating layer through in-line coating and, in this case, a water-dispersible emulsion is preferably used for conducting the in-line coating.

In this regard, a constitutional composition of the emulsion suitable to form the easy-adhesive acryl coating layer is substantially the same as described above and the coating process may be executed to provide a dry coating thickness of 50 to 300nm after stretching.

After applying the acryl emulsion to form a easy-adhesive acryl coating layer, the stretching is performed in a transverse direction. The transverse stretching may be executed by using a tenter.

Next, in order to remove moisture contained in the easy-adhesive acryl coating layer, cure the acryl coating layer and prevent shrinkage of the film, drying and heat-setting processes are employed.

Thereafter, the fluorine coating composition is applied through off-line coating to form a fluorine coating layer and, in this case, the fluorine coating layer may have a dry coating thickness of 10 to 30*µ*m.

### Advantageous Effects of Invention

The back sheet for a solar cell module according to the present invention may be fabricated by a simple process at reduced production costs and exhibit excellent adhesiveness to a sealing material.

### Mode for the Invention

Hereinafter, the following description will be given to stipulate an embodiment of the present invention, without particular limitation thereto.

Measurement of physical properties is described below.

### 1. Adhesiveness

ASTM D 3359-97 'standard Test Methods For Measuring Adhesion By Tape Test' was employed.

Assessment standards are as follows:
A: Coating layer was not stripped
B: 10% of coating layer was stripped
C: 14% of coating layer was stripped
D: 31% of coating layer was stripped
Pass: A
Fail: B, C, D

### 2. UV shielding

Measurement equipment: Barian Cary 5000 UV-visible spectrophotometer was used.

UV transmittance (%): A fluorine coating layer was directed toward a UV light source after fabricating a back sheet and UV transmittance was measured throughout an overall UV wavelength (200 to 400nm). A measured value to show UV transmittance at 400nm among the measured range was used.
Pass: UV transmittance of less than 1%
Fail: UV transmittance of 1% or more

### [EXAMPLE 1]

### Preparation of easy-adhesive acryl emulsion (1)

4wt.% of an acryl binder resin (in terms of solid content of Primal-3208; Dow Co.), 1.5wt.% of methoxymethyl methylol melamine as a melamine based cross-linking agent, 0.15wt.% of ammonium thiocyanate as a curing agent and 94.35wt.% of water were mixed to prepare an acryl emulsion.

### Preparation of polyester film for back sheet

A polyethylene terephthalate chip after removing moisture to 100 ppm or less was placed in a melt extruder and molten. While extruding the molten product through a T-die, the product was rapidly cooled in a casting drum at a surface temperature of 20°C and solidified to produce a polyethylene terephthalate sheet having a thickness of 2000*µ*m.

After stretching the produced polyethylene terephthalate sheet at 110°C in a machine direction (MD) to reach 3.5 times, the stretched sheet was cooled at room temperature. Following this, the easy-adhesive acryl emulsion (1) was applied to one side of the sheet by bar coating and, after preheating and drying the same at 140°C, transverse direction (TD) was conducted 3.5 times. Then, heat treatment was conducted at 235°C by using 5-stage tenter, 10% relaxation was executed in both of the MD and TD at 200°C, followed by heat-setting, resulting in a biaxial-stretched film having a thickness of 250*µ*m, which has a easy-adhesive acryl coating layer formed on one side of the film. After stretching, the easy-adhesive acryl coating layer had a dry coating thickness of 80nm.

### Fabrication of back sheet for solar cell module

A fluorine coating composition containing 20wt.% of polyvinylidene fluoride, 5wt.% of titanium dioxide (rutile type, particle diameter: 220nm) and 75wt.% of a solvent (dimethyl acetamide), which are dispersed therein by sand-milling, was applied to a top side of the acryl coating layer formed on the biaxially stretched polyester film, in a dry coating thickness of 15*µ*m.

Physical properties of the fabricated back sheet are shown in TABLE 1.

### [EXAMPLE 2]

A back sheet was fabricated by the same procedures as described in Example 1, except that a content of titanium dioxide was controlled to 6wt.% during fabrication of the back sheet.

Physical properties of the fabricated back sheet are shown in TABLE 1.

### [EXAMPLE 3]

A back sheet was fabricated by the same procedures as described in Example 1, except that a content of titanium dioxide was controlled to 7wt.% during fabrication of the back sheet.

Physical properties of the fabricated back sheet are shown in TABLE 1.

### [EXAMPLE 4]

A back sheet was fabricated by the same procedures as described in Example 1, except that a content of titanium dioxide was controlled to 8wt.% during fabrication of the back sheet.

Physical properties of the fabricated back sheet are shown in TABLE 1.

### [EXAMPLE 5]

A back sheet was fabricated by the same procedures as described in Example 1, except that polyvinylidene fluoride was replaced by tetrafluoroethylene-hexafluoropropylene-vinylidene fluoride (THV) and titanium dioxide having a particle diameter of 150nm was used during fabrication of the back sheet.

Physical properties of the fabricated back sheet are shown in TABLE 1.

### [COMPARATIVE EXAMPLE 1]

A back sheet was fabricated by the same procedures as described in Example 1, except that a fluorine coating composition free from titanium dioxide was used during fabrication of the back sheet.

That is, a fluorine coating composition containing 20wt.% of polyvinylidene fluoride and 80wt.% of a solvent (dimethyl acetamide) was applied in a dry coating thickness of 15*µ*m.

Physical properties of the fabricated back sheet are shown in TABLE 1.

### [COMPARATIVE EXAMPLE 2]

A back sheet was fabricated according to the procedures in Example 1, such that a fluorine coating composition containing 20wt.% of polyvinylidene fluoride, 4wt.% of titanium dioxide (rutile type, particle diameter: 220nm) and 80wt.% of a solvent (dimethyl acetamide) which are dispersed therein by sand-milling was applied in a dry coating thickness of 15*µ*m during fabrication of the back sheet.

Physical properties of the fabricated back sheet are shown in TABLE 1.

### [COMPARATIVE EXAMPLE 3]

A back sheet was fabricated by the same procedures as described in Example 1, except that a dry coating thickness of the applied acryl coating layer is 40nm.

Physical properties of the fabricated back sheet are shown in TABLE 1.

### [COMPARATIVE EXAMPLE 4]

A fluorine coating composition containing 20wt.% of polyvinylidene fluoride, 5wt.% of titanium dioxide (rutile type, particle diameter: 220nm) and 75wt.% of a solvent (dimethyl acetamide) which are dispersed therein by sand-milling was applied in a dry coating thickness of 15*µ*m to a top side of a biaxially stretched polyester film which was surface-treated via corona discharge.

Physical properties of the fabricated back sheet are shown in TABLE 1.

**[TABLE 1]**

| | adhesivene ss | UV shielding property |
|---|---|---|
| Example 1 | A | Pass |
| Example 2 | A | Pass |
| Example 3 | A | Pass |
| Example 4 | A | Pass |
| Example 5 | A | Pass |
| Comparative Example 1 | A | Fail |
| Comparative Example 2 | A | Fail |
| Comparative Example 3 | D | Pass |
| Comparative Example 4 | D | Pass |

### Industrial Applicability

The back sheet for a solar cell module according to the present invention may be fabricated by a simple process at reduced production costs and exhibit excellent adhesiveness to a sealing material.

## Claims

1. A back sheet for a solar cell module, the back sheet comprising:
a polyester film layer having a easy-adhesive acryl coating layer formed on either or both sides thereof; and
a fluorine coating layer prepared by applying a fluorine coating composition containing titanium dioxide as well as a fluoride resin selected from polyvinylidene fluoride or tetrafluoroethylene-hexafluoropropylene-vinylidene fluoride, to a top side of the acryl coating layer,
wherein the easy-adhesive acryl coating layer is formed by applying an acrylic emulsion containing 2 to 10wt.% of an acryl binder resin, 0.2 to 4wt.% of a melamine based cross-linking agent, 0.02 to 0.5wt.% of a curing catalyst and water as the remaining amount to equal 100.wt%.

2. The back sheet of claim 1, wherein the titanium dioxide is a rutile type titanium dioxide having a particle diameter of 150 to 300nm.

3. The back sheet of claim 1, wherein the easy-adhesive acryl coating layer is applied through in-line coating during the stretching of the polyester film by using an acryl emulsion containing 2 to 10wt.% of an acryl binder resin, 0.2 to 4wt.% of a melamine based cross-linking agent, 0.02 to 0.5wt.% of a curing catalyst and water as the remaining amount to equal 100wt.% during the stretching of the polyester film.

4. The back sheet of claim 3, wherein the melamine based cross-linking agent comprises methoxymethyl methylol melamine.

5. The back sheet of claim 1, wherein the easy-adhesive acryl coating layer has a dry coating thickness of 50 to 300nm and the fluorine coating layer has a dry coating thickness of 10 to 30*µ*m.

6. The back sheet of claim 3, wherein the stretching is a biaxially stretching process that applies the acryl emulsion after stretching in a machine direction then conducts stretching in a transverse direction.

7. A method of fabricating a back sheet for a solar cell module, the method comprising:
a) preparing a polyester sheet by melt-extruding a polyester resin;
b) stretching the polyester sheet in a machine direction;
c) applying an acryl emulsion that contains 2 to 10wt.% of an acryl binder resin, 0.2 to 4wt.% of a melamine based cross-linking agent, 0.02 to 0.5wt.% of a curing catalyst and water as the remaining amount to equal 100wt.% to either or both sides of the polyester film stretched in the machine direction, to form a easy-adhesive acryl coating layer, and then, stretching the coated polyester film in a transverse direction;
d) heat-setting the biaxial oriented polyester film; and
e) applying a fluorine coating composition that contains titanium dioxide as well as a fluorine resin selected from polyvinylidene fluoride or tetrafluoroethylene-hexafluoropropylene-vinylidene fluoride, to a top side of the easy-adhesive acryl coating layer, through off-line coating, in order to form a fluorine coating layer.

8. The method of claim 7, wherein the titanium dioxide is a rutile type titanium dioxide having a particle diameter of 150 to 300nm and a content thereof ranges from 30 to 40wt.%.

9. The method of claim 7, wherein the melamine based cross-linking agent comprises methoxymethyl methylol melamine.

10. The method of claim 7, wherein the easy-adhesive acryl coating layer has a dry coating thickness of 50 to 300nm and the fluorine coating layer has a dry coating thickness of 10 to 30*µ*m.

## Patentansprüche

1. Rückseitenfolie für ein Solarzellenmodul, wobei die Rückseitenfolie umfasst:
eine Polyesterfilmschicht mit einer auf einer oder beiden Seiten hiervon gebildeten leichtklebenden Acrylüberzugsschicht; und
eine Fluor-Überzugsschicht, hergestellt durch Auftragen einer Fluor-Beschichtungszusammensetzung, enthaltend Titandioxid sowie ein Fluoridharz, gewählt aus Polyvinylidenfluorid oder Tetrafluorethylen-Hexafluorpropylen-Vinylidenfluorid, auf eine Oberseite der Acrylüberzugsschicht,
wobei die leichtklebende Acrylüberzugsschicht gebildet ist durch Auftragen einer Acrylemulsion, enthaltend 2 bis 10 Gew.-% eines Acrylbindemittelharzes, 0,2 bis 4 Gew.-% eines Melamin-basierten Vernetzungsmittels, 0,02 bis 0,5 Gew.-% eines Härtungskatalysators und Wasser als restliche Menge, um 100 Gew.-% zu ergeben.

2. Rückseitenfolie nach Anspruch 1, wobei das Titandioxid ein Titandioxid vom Rutiltyp ist mit einem Teilchendurchmesser von 150 bis 300 nm.

3. Rückseitenfolie nach Anspruch 1, wobei die leichtklebende Acrylüberzugsschicht durch Inlinebeschichtung während dem Recken des Polyesterfilms aufgebracht wird durch Verwendung einer Acrylemulsion, enthaltend 2 bis 10 Gew.-% eines Acrylbindemittelharzes, 0,2 bis 4 Gew.-% eines Melamin-basierten Vernetzungsmittels, 0,02 bis 0,5 Gew.-% eines Härtungskatalysators und Wasser als restliche Menge, um 100 Gew.-% zu ergeben, während dem Recken des Polyesterfilms.

4. Rückseitenfolie nach Anspruch 3, wobei das Melamin-basierte Vernetzungsmittel Methoxymethylmethylolmelamin umfasst.

5. Rückseitenfolie nach Anspruch 1, wobei die leichtklebende Acrylüberzugsschicht eine Trockenbeschichtungsdicke von 50 bis 300 nm aufweist und die Fluor-Überzugsschicht eine Trockenbeschichtungsdicke von 10 bis 30 µm aufweist.

6. Rückseitenfolie nach Anspruch 3, wobei das Recken ein biaxiales Reckverfahren ist, bei dem die Acrylemulsion nach dem Recken in einer Maschinenrichtung aufgebracht wird und dann das Recken in einer Querrichtung erfolgt.

7. Verfahren zur Herstellung einer Rückseitenfolie für ein Solarzellenmodul, wobei das Verfahren umfasst:
a) Herstellen einer Polyesterfolie durch Schmelzextrudieren eines Polyesterharzes;
b) Recken der Polyesterfolie in einer Maschinenrichtung;
c) Auftragen einer Acrylemulsion, die 2 bis 10 Gew.-% eines Acrylbindemittelharzes, 0,2 bis 4 Gew.-% eines Melamin-basierten Vernetzungsmittels, 0,02 bis 0,5 Gew.-% eines Härtungskatalysators und Wasser als die restliche Menge enthält, um 100 Gew.-% zu ergeben, auf eine oder beide Seiten des in der Maschinenrichtung gereckten Polyesterfilms, um eine leichtklebende Acrylüberzugsschicht zu bilden, und danach Recken des beschichteten Polyesterfilms in einer Querrichtung;
d) Thermofixieren des biaxial orientierten Polyesterfilms; und
e) Aufbringen einer Fluor-Beschichtungszusammensetzung, die Titandioxid sowie ein Fluorharz enthält, gewählt aus Polyvinylidenfluorid oder Tetrafluorethylen-Hexafluorpropylen-Vinylidenfluorid, auf eine Oberseite der leichtklebenden Acrylüberzugsschicht durch Offline-Beschichtung, um eine Fluor-Überzugsschicht zu bilden.

8. Verfahren nach Anspruch 7, wobei das Titandioxid ein Titandioxid vom Rutiltyp ist mit einem Teilchendurchmesser von 150 bis 300 nm, und dessen Gehalt im Bereich von 30 bis 40 Gew.-% liegt.

9. Verfahren nach Anspruch 7, wobei das Melamin-basierte Vernetzungsmittel Methoxymethylmethylolmelamin umfasst.

10. Verfahren nach Anspruch 7, wobei die leichtklebende Acrylüberzugsschicht eine Trockenbeschichtungsdicke von 50 bis 300 nm aufweist und die Fluor-Überzugsschicht eine Trockenbeschichtungsdicke von 10 bis 30 µm aufweist.

## Revendications

1. Une feuille arrière pour un module de cellule solaire, la feuille arrière comprenant:
une couche de film de polyester ayant une couche de revêtement acrylique facilement adhésive formée sur l'un ou l'autre ou les deux côtés de celle-ci; et
une couche de revêtement de fluor préparée en appliquant une composition de revêtement de fluor contenant du dioxyde de titane ainsi qu'une résine fluorée choisie parmi le fluorure de polyvinylidène ou le fluorure de tétrafluoroéthylène-hexafluoropropylène-vinylidène sur un côté supérieur de la couche de revêtement acrylique,
dans lequel la couche de revêtement acrylique facilement adhésive est formée en appliquant une émulsion acrylique contenant de 2 à 10 % en poids d'une résine de liaison acrylique, de 0,2 à 4 % en poids d'un agent de réticulation à base de mélamine, de 0,02 à 0,5 % en poids d'un catalyseur de durcissement et de l'eau en tant que la quantité restante pour rendre 100 % en poids.

2. La feuille arrière selon la revendication 1, dans laquelle le dioxyde de titane est un dioxyde de titane de type rutile ayant un diamètre de particule de 150 à 300 nm.

3. La feuille arrière selon la revendication 1, dans laquelle la couche de revêtement acrylique facilement adhésive est appliquée par le moyen d'un revêtement en ligne pendant l'étirage du film de polyester en utilisant une émulsion acrylique contenant de 2 à 10% en poids d'une résine liante acrylique, de 0,2 à 4% en poids d'un agent de reticulation à base de mélamine, de 0,02 à 0,5% en poids d'un catalyseur de durcissement et de l'eau en tant que quantité restante pour rendre 100% en poids pendant l'étirage du film de polyester.

4. La feuille arrière selon la revendication 3, dans laquelle l'agent de réticulation à base de mélamine comprend de la mélamine de méthoxyméthylméthylol.

5. La feuille arrière selon la revendication 1, dans laquelle la couche de revêtement acrylique facilement adhésive a une épaisseur de revêtement sec de 50 à 300 nm et la couche de revêtement de fluor a une épaisseur de revêtement sec de 10 à 30 µm.

6. La feuille arrière selon la revendication 3, dans laquelle l'étirage est un processus d'étirage biaxial qui applique l'émulsion acrylique après l'étirement dans une direction de la machine, puis qui conduit l'étirage dans une direction transversale.

7. Un procédé de fabrication d'une feuille arrière pour un module de cellule solaire, le procédé comprenant:
a) la préparation d'une feuille de polyester par extrusion à l'état fondu d'une résine de polyester;
b) l'étirage de la feuille de polyester dans une direction de la machine;
c) l'application d'une émulsion acrylique contenant de 2 à 10% en poids d'une résine liant acrylique, de 0,2 à 4% en poids d'un agent réticulant à base de mélamine, de 0,02 à 0,5% en poids d'un catalyseur de durcissement et de l'eau en tant que quantité restante pour rendre 100% en poids sur l'un ou l'autre ou les deux côtés du film de polyester étiré dans la direction de la machine, pour former une couche de revêtement acrylique facilement adhésive, et puis, l'étirement du film de polyester revêtu dans une direction transversale;
d) le thermodurcissement du film de polyester orienté biaxialement; et
e) l'application d'une composition de revêtement de fluor contenant du dioxyde de titane ainsi qu'une résine fluorée choisie parmi le fluorure de polyvinylidène ou le fluorure de tétrafluoroéthylène-hexafluoropropylène-vinylidène, sur un côté supérieur de la couche de revêtement acrylique facilement adhésive, par le moyen d'un revêtement hors ligne, afin de former une couche de revêtement de fluor.

8. Le procédé selon la revendication 7, dans lequel le dioxyde de titane est un dioxyde de titane de type rutile ayant un diamètre de particule de 150 à 300 nm et une teneur de celui-ci est dans la page entre 30 à 40% en poids.

9. Le procédé selon la revendication 7, dans lequel l'agent de réticulation à base de mélamine comprend de la mélamine de méthoxyméthylméthylol.

10. Le procédé selon la revendication 7, dans lequel la couche de revêtement acrylique facilement adhésive a une épaisseur de revêtement sec de 50 à 300 nm et la couche de revêtement de fluor a une épaisseur de revêtement sec de 10 à 30 µm.
